# EUROPEAN PATENT APPLICATION

(11) **EP 4 787 434 A1**
(43) Date of publication of application: **05.08.2026**
(21) Application number: 24881237.2
(22) Date of filing: 26.08.2024
(51) Int. Cl.: H01L 23/31, H01L 23/538

(54) **ELECTRONIC ASSEMBLY AND COMMUNICATION DEVICE**

(30) Priority: 24.10.2023 CN 202311388970
(71) Applicant: HUAWEI TECHNOLOGIES CO., LTD., Shenzhen 518129 (CN)
(72) Inventor: HUANG, Shujun, Shenzhen, Guangdong 518129 (CN); LIN, Yanhai, Shenzhen, Guangdong 518129 (CN)
(74) Representative: Gill Jennings & Every LLP
(86) International application number: PCT/CN2024/114605
(87) International publication number: WO 2025/086869

(57) **Abstract**

This application provides an electronic assembly and a communication device. The electronic assembly includes a first circuit board and a power assembly. A first input pad, a first output pad, and a first ground pad are disposed on the power assembly. A second input pad, a second output pad, and a second ground pad are disposed on the first circuit board. The power assembly has a first projection area on the first circuit board. A first surface of the first circuit board has a first demetallized area, and the first demetallized area is located between the second input pad and the second output pad. A second surface of the first circuit board has a second demetallized area, and a projection of the second demetallized area onto the first surface is located between the second input pad and the second output pad. The power assembly and the first circuit board are attached to each other, so that a parasitic parameter generated during assembling of the power part and the first circuit board can be reduced, to improve performance of the electronic assembly. In addition, the demetallized area may reduce impact on a radio frequency signal path area of a radio frequency power component.

## Description

### CROSS-REFERENCE TO RELATED APPLICATIONS

This application claims priority to Chinese Patent Application No. 202311388970.9, filed with the China National Intellectual Property Administration on October 24, 2023 and entitled "ELECTRONIC ASSEMBLY AND COMMUNICATION DEVICE", which is incorporated herein by reference in its entirety.

### TECHNICAL FIELD

This application relates to the field of communication device technologies, and in particular, to an electronic assembly and a communication device.

### BACKGROUND

A radio frequency high-power component is a key component of a transmitter system and has a signal amplification function. The radio frequency high-power component is mainly configured to convert direct current energy supplied by a power supply into alternating current energy. During conversion, because a part of energy is converted into heat energy and is dissipated, higher output power of the radio frequency high-power component indicates a higher heat dissipation requirement.

Conventional radio frequency high-power components are typically implemented as drop-in (drop-in) packages mounted on a surface of a flange, and input and output pins of the radio frequency high-power component extend out of the packaging layer. During assembling of power assembly, a slot is machined in a circuit board, the packaging member is dropped in the slot, and the input and output pins are then connected to the circuit board. However, an assembling tolerance exists in the process of assembling the packaging member and the circuit board, and the assembled power assembly introduces parasitic parameters, resulting in degraded performance of the power assembly.

### SUMMARY

This application provides an electronic assembly and a communication device, to reduce tolerance and parasitic parameters of a power assembly generated during assembling of the power assembly and a circuit board, so that performance of the electronic assembly is improved.

According to a first aspect, this application provides an electronic assembly. Specifically, the electronic assembly includes a power assembly and a first circuit board. The power assembly includes a flange, a packaging layer, and a radio frequency power component. The packaging layer is located on a side that is of the flange and that faces the first circuit board, and the packaging layer is connected to the flange. The radio frequency power component is disposed in the packaging layer. A first input pad, a first output pad, and a first ground pad are disposed on a surface of a side that is of the packaging layer and that faces the first circuit board, the first input pad and the first output pad are electrically connected to the radio frequency power component separately, and the first ground pad is electrically connected to the flange. A second input pad, a second output pad, and a second ground pad are disposed on a first surface that is of the first circuit board and that faces the power assembly, the second input pad and the first input pad are disposed opposite to each other and electrically connected, the second output pad and the first output pad are disposed opposite to each other and electrically connected, and the second ground pad and the first ground pad are disposed opposite to each other and electrically connected. Along a direction perpendicular to the first circuit board, the power assembly has a first projection area on the first surface. The first surface has a first demetallized area, and the first demetallized area is located in the first projection area and located between the second input pad and the second output pad. A second surface that is of the first circuit board and that faces away from the power assembly has a second demetallized area, and along the direction perpendicular to the first circuit board, a projection of the second demetallized area onto the first surface is located in the first projection area and located between the second input pad and the second output pad.

In the electronic assembly in this application, the power assembly and the first circuit board are disposed opposite to each other, and the power assembly is attached to the first circuit board in a surface assembling manner, so that an assembling tolerance along a direction perpendicular to the first circuit board and an assembling tolerance along a direction parallel to the first circuit board can be reduced. In this way, assembling consistency is improved, and tolerance and parasitic parameters of the power assembly generated during assembling of the power part and the first circuit board are reduced, to improve performance of the electronic assembly. In addition, the first demetallized area and the second demetallized area are separately located between the second input pad and the second output pad, to reduce impact on a radio frequency signal path area of the radio frequency power component.

Relative positions of the first demetallized area and the second demetallized area are not limited. In a possible implementation, along the direction perpendicular to the first circuit board, the projection of the second demetallized area onto the first surface at least partially overlaps the first demetallized area.

In another possible implementation, the projection of the second demetallized area onto the first surface may fully overlap the first demetallized area.

In another possible implementation, the projection of the second demetallized area onto the first surface may not overlap the first demetallized area.

When the first demetallized area and the second demetallized area are specifically disposed, in a possible implementation, an insulating dielectric layer is disposed between the first demetallized area and the second demetallized area, and the insulating dielectric layer is connected to the first demetallized area and the second demetallized area. In other words, at least a part of a metal layer that is on the first circuit board and that is located in the first demetallized area and the second demetallized area is removed, so that impact on the radio frequency signal path area can be reduced.

In a possible implementation, the insulating dielectric layer may be provided with an open slot, and an opening of the open slot is located in the first demetallized area or the second demetallized area. In other words, the opening of the open slot may face the power assembly, or may face away from the power assembly. Herein, a quantity of open slots is not specifically limited. In another possible implementation, the insulating dielectric layer may be provided with a first through via, and the first through via penetrates the insulating dielectric layer, and is connected to the first demetallized area and the second demetallized area.

When the first demetallized area and the second demetallized area are specifically disposed, in another possible implementation, a second through via may be provided between the first demetallized area and the second demetallized area, and the second through via is connected to the first demetallized area and the second demetallized area. In other words, all media (including a metal medium and a non-metal medium) that are on the first circuit board and that are located in the first demetallized area and the second demetallized area may be removed, to reduce impact on the radio frequency signal path area.

In a possible implementation, a first conductor and a second conductor are disposed on the first circuit board, the first conductor is located in the first demetallized area and the second demetallized area, and is connected to the second input pad, and the second conductor is located in the first demetallized area and the second demetallized area, and is connected to the second output pad. Therefore, the first demetallized area and the second demetallized area are separately located between the first conductor and the second conductor, the second input pad is electrically connected to another circuit through the first conductor, and the second output pad is electrically connected to another circuit through the second conductor.

In a possible implementation, a routing portion is disposed on the second surface, and the second demetallized area is disposed in the routing portion. The first conductor is electrically connected to the second input pad and the third routing portion, and the second conductor is electrically connected to the second output pad and the third routing portion.

In a possible implementation, the first input pad and the first output pad are electrically connected to the radio frequency power component separately through a conductor. Specifically, the packaging layer is provided with a first penetrating via and a second penetrating via, the first penetrating via and the second penetrating via penetrate the packaging layer separately, a third conductor is disposed in the first penetrating via, the first input pad is electrically connected to the radio frequency power component through the third conductor, a fourth conductor is disposed in the second penetrating via, and the second input pad is electrically connected to the radio frequency power component through the fourth conductor.

In a possible implementation, the flange is electrically connected to the first ground pad through a conductor. Specifically, a fifth conductor is disposed on a surface of a side that is of the flange and that faces the first circuit board, and the fifth conductor penetrates the packaging layer, and is electrically connected to the flange and the first ground pad.

In a possible implementation, the electronic assembly is a dual-channel assembly. A third input pad, a third output pad, and a third ground pad are further disposed on the surface of the side that is of the packaging layer and that faces the first circuit board, the third input pad and the third output pad are electrically connected to the radio frequency power component separately, and the third ground pad is electrically connected to the flange. A fourth input pad, a fourth output pad, and a fourth ground pad are further disposed on the first surface, the fourth input pad and the third input pad are disposed opposite to each other and electrically connected, the fourth output pad and the third output pad are disposed opposite to each other and electrically connected, and the fourth ground pad and the third ground pad are disposed opposite to each other and electrically connected. The first surface further has a third demetallized area, and the third demetallized area is located in the first projection area and located between the fourth input pad and the fourth output pad. The second surface further has a fourth demetallized area, and along the direction perpendicular to the first circuit board, a projection of the fourth demetallized area onto the first surface is located in the first projection area and located between the fourth input pad and the fourth output pad.

A discrete component is further disposed on the first circuit board. In a possible implementation, a first discrete component, a second discrete component, a third discrete component, and a fourth discrete component are disposed on the side that is of the first circuit board and that faces away from the power assembly, the first discrete component and the second discrete component are respectively located on two sides of the second demetallized area, and the third discrete component and the fourth discrete component are respectively located on two sides of the fourth demetallized area.

In a possible implementation, the electronic assembly further includes a first heat sink, and the first heat sink is disposed on a side that is of the flange and that faces away from the first circuit board, and is configured to dissipate heat for the power assembly.

In a possible implementation, a first thermally conductive layer is disposed between the flange and the first heat sink, to increase heat transfer efficiency between the flange and the first heat sink.

In a possible implementation, the electronic assembly further includes a second circuit board, the second circuit board is located on a side that is of the first circuit board and that faces the power assembly, the second circuit board is connected to the first circuit board, and the power assembly is disposed in the second circuit board.

According to a second aspect, this application further provides a communication device. The communication device includes the electronic assembly in the first aspect. In the communication device in this application, the power assembly and the first circuit board of the electronic assembly are disposed opposite to each other, and the power assembly is attached to the first circuit board in a surface assembling manner, so that an assembling tolerance along a direction perpendicular to the first circuit board and an assembling tolerance along a direction parallel to the first circuit board can be reduced. In this way, assembling consistency is improved, and tolerance and parasitic parameters of the power assembly generated during assembling of the power part and the first circuit board are reduced, to improve performance of the communication device. In addition, the first demetallized area and the second demetallized area are separately located between the second input pad and the second output pad, to reduce impact on a radio frequency signal path area of the radio frequency power component.

### BRIEF DESCRIPTION OF DRAWINGS

FIG. 1 is a diagram of a communication system according to an embodiment of this application;
FIG. 2 is a diagram of a communication device according to an embodiment of this application;
FIG. 3 is a diagram of a transmitter according to an embodiment of this application;
FIG. 4 is a diagram of an electronic assembly according to an embodiment of this application;
FIG. 5 is a diagram of a power assembly according to an embodiment of this application;
FIG. 6 is another diagram of a power assembly according to an embodiment of this application;
FIG. 7 is another diagram of a power assembly according to an embodiment of this application;
FIG. 8 is a diagram of a first circuit board according to an embodiment of this application;
FIG. 9 is another diagram of a first circuit board according to an embodiment of this application;
FIG. 10 is another diagram of a first circuit board according to an embodiment of this application;
FIG. 11 is another diagram of a first circuit board according to an embodiment of this application;
FIG. 12 is another diagram of a first circuit board according to an embodiment of this application;
FIG. 13 is another diagram of a first circuit board according to an embodiment of this application;
FIG. 14 is another diagram of an electronic assembly according to an embodiment of this application;
FIG. 15 is another diagram of an electronic assembly according to an embodiment of this application;
FIG. 16 is another diagram of an electronic assembly according to an embodiment of this application;
FIG. 17 is another diagram of an electronic assembly according to an embodiment of this application; and
FIG. 18 is another diagram of an electronic assembly according to an embodiment of this application.

### Reference numerals:

10: communication system; 11: communication device; 12: terminal device;
30: electronic assembly; 31: power assembly; 32: first circuit board;
33: discrete component; 34: first heat sink; 35: first thermally conductive layer;
36: second circuit board; 37: second heat sink; 38: second thermally conductive layer;
33a: first discrete component; 33b: second discrete component; 33c: third discrete component;
33d: fourth discrete component; 110: transmitter; 311: flange;
312: radio frequency power component; 313: packaging layer; 314: first input pad;
315: first output pad; 316: first ground pad; 317: conductive circuit;
318: third input pad; 319: third output pad; 321: second input pad;
322: second output pad; 323: second ground pad; 324: insulating dielectric layer;
325: open slot; 326: first through via; 327: metal portion;
328: second through via; 329: routing portion; 3111: conductive pillar;
3131: first conductor; 3132: second conductor; 3211: third conductor;
3221: fourth conductor; R0: first projection area; R1: first demetallized area;
R2: second demetallized area; R4: fourth demetallized area; S1: first surface;
S2: second surface.

### DESCRIPTION OF EMBODIMENTS

To make the objectives, technical solutions, and advantages of this application clearer, the following further describes this application in detail with reference to the accompanying drawings.

To facilitate understanding of the electronic assembly provided in embodiments of this application, the following describes an application scenario of the hinge mechanism. The electronic assembly provided in embodiments of this application may be used in various communication systems, including but not limited to: a global system for mobile communications (global system for mobile communications, GSM), a code division multiple access (code division multiple access, CDMA) system, a wideband code division multiple access (wideband code division multiple access, WCDMA) system, a general packet radio service (general packet radio service, GPRS) system, a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a 5G system, a new radio (new radio, NR) system, a future 6th generation mobile communication technology system, or the like.

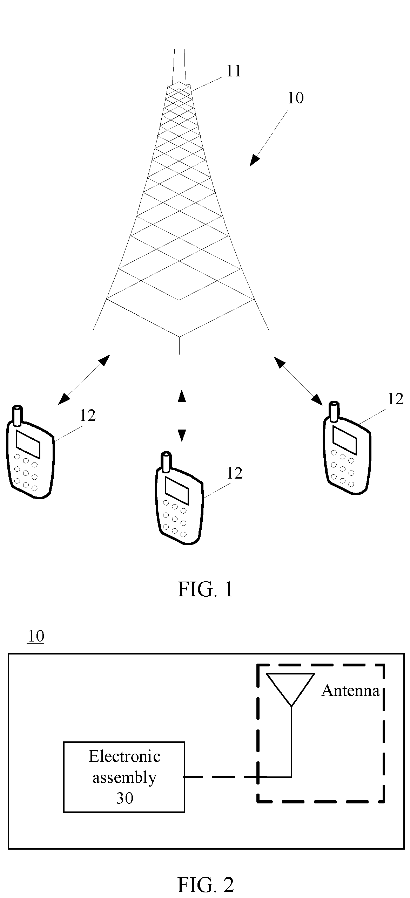

FIG. 1 is a diagram of a communication system according to an embodiment of this application. As shown in FIG. 1, the communication system 10 includes at least one communication device 11. The communication device 11 provided in this embodiment of this application may be a radio access network (radio access network, RAN) node/device that connects a terminal device to a wireless network. The communication device 11 may also be referred to as an access network device or a radio access device. For example, the communication device 11 may be a base station. The base station includes but is not limited to: an evolved NodeB (evolved NodeB, eNB or eNodeB) in an LTE system, a NodeB (NodeB, NB) in a WCDMA system, a base transceiver station (base transceiver station, BTS) in a GSM or CDMA system, a base station in a future 5G network, a base station in a future evolved PLMN network, a home base station, a new radio base station, a vehicle-mounted device, a wearable device, a radio controller in a cloud radio access network (cloud radio access network, CRAN) scenario, a relay station, an access point, a transmitting and receiving point (transmitting and receiving point, TRP), a transmitting point (transmitting point, TP), a baseband unit (building base band unit, BBU), a remote radio unit (remote radio unit, RRU), an AAU, a radio head (remote radio head, RRH), a central unit (central unit, CU), a distributed unit (distributed unit, DU), a positioning node, and the like. The base station may be fixed, or may be mobile, and the base station may support networks of a same access technology or different access technologies. A specific technology and a specific device form that are used by the communication device 11 are not limited in embodiments of this application. Certainly, the communication device 11 may alternatively be a transmitter, a radar, or another device having a similar function.

The communication system 10 may be configured to communicate with at least one terminal device 12, and the at least one terminal device 12 may communicate with the at least one communication device 11. When the communication device 11 communicates with the terminal device 12, one communication device 11 may manage one or more terminal devices 12. The terminal device 12 is a device configured to communicate with the communication device 11, and includes but is not limited to: user equipment (user equipment, UE), an access terminal, a subscriber unit, a subscriber station, a mobile station, a mobile station (mobile station, MS), a mobile terminal (mobile terminal, MT), a remote station, a remote terminal, a mobile device, a user terminal, a terminal, a wireless communication device, a user agent, or a user apparatus. For example, the terminal device 12 may be a device that provides a user with voice and/or data connectivity, and may be configured to connect a person, an object, and a machine, for example, a handheld device or a vehicle-mounted device with a wireless connection function. Alternatively, the terminal device 12 may be: a mobile phone, a tablet computer, a notebook computer, a palmtop computer, a mobile internet device (mobile internet device, MID), a wearable device, a virtual reality (virtual reality, VR) device, an augmented reality (augmented reality, AR) device, a wireless terminal in industrial control, a wireless terminal in self driving, a wireless terminal in remote surgery, a wireless terminal in a smart grid, a wireless terminal in transportation safety, a wireless terminal in a smart city, a wireless terminal in a smart home, and the like.

FIG. 2 is a diagram of a communication device according to an embodiment of this application. As shown in FIG. 2, the communication device 11 includes an electronic assembly 30. The electronic assembly 30 is configured to increase a power level of a signal, to expand transmission coverage of the communication device 11. Optionally, the communication device 11 further includes an antenna, and the antenna is connected to the electronic assembly 30 by using a signal, so that a signal obtained after the electronic assembly 30 increases a power level is finally sent to the outside through the antenna.

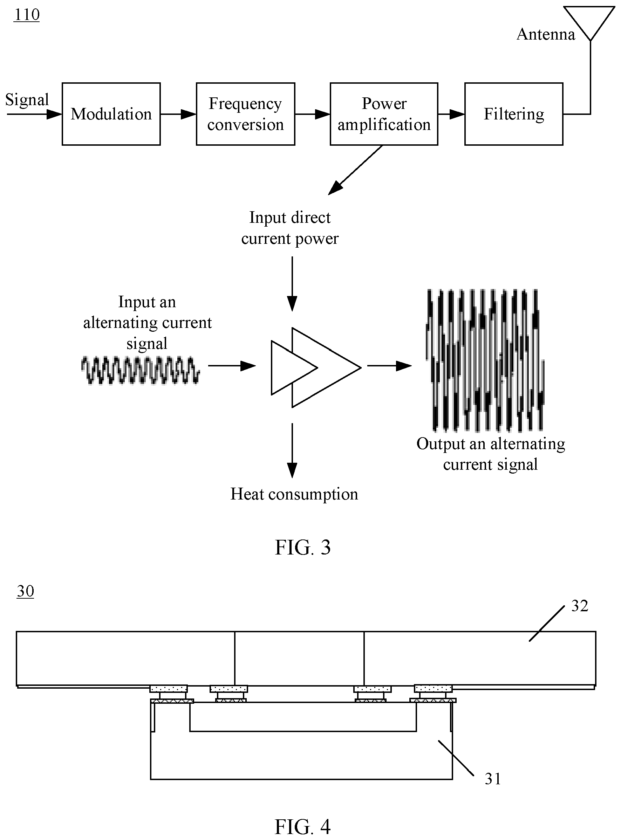

FIG. 3 is a diagram of a transmitter according to an embodiment of this application. As shown in FIG. 3, in an embodiment, the communication device 11 may be the transmitter 110. The transmitter 110 may include a modulation module, a frequency conversion module, a power module (for example, a power amplification module in FIG. 3), a filtering module, and an antenna. The power module includes at least one electronic assembly. Each electronic assembly includes a power assembly.

In conventional power assemblies, radio frequency power component are typically implemented as drop-in (drop-in) packages and embedded into a slot of a circuit board. During assembling, input and output pins of the power assembly are electrically connected to the circuit board. However, due to processing errors, a plane in which the input and output pins are located may not be in a same plane as a routing layer of the circuit board. Therefore, the input and output pins need to be bent to be soldered to the routing layer of the circuit board. This causes more parasitic parameters of the power assembly. In addition, the slot of the circuit board may have a size deviation due to processing errors, and consequently, inconsistency exists between an output end and/or an input end after the power assembly is embedded into the slot. As a result, this results in fluctuation of performance of the electronic assembly, and compromises performance of the electronic assembly.

In view of this, this application provides an electronic assembly and a communication device, to reduce tolerance and parasitic parameters of the power assembly generated during assembling of the power assembly and the circuit board, so that performance of the electronic assembly is improved.

It should be noted that, terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

FIG. 4 is a diagram of an electronic assembly according to an embodiment of this application. As shown in FIG. 4, the electronic assembly 30 includes a power assembly 31 and a first circuit board 32. The power assembly 31 is disposed opposite to the first circuit board 32, and the power assembly 31 is electrically connected to the first circuit board 32. The following separately describes in detail the power assembly 31 and the first circuit board 32.

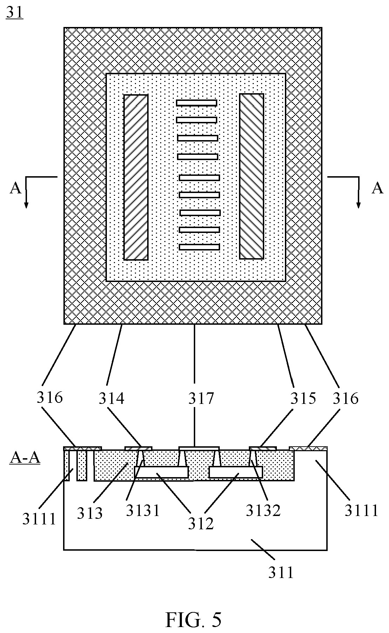

FIG. 5 is a diagram of a power assembly according to an embodiment of this application. As shown in FIG. 5, the power assembly 31 includes a flange 311, a radio frequency power component 312, and a packaging layer 313. Specifically, the flange 311 is a metal carrier, and has a thermal conduction function and an electrical conduction function. The packaging layer 313 is located on a side that is of the flange 311 and that faces the first circuit board 32, and the packaging layer 313 is connected to the flange 311. The radio frequency power component 312 is disposed in the packaging layer 313. In other words, the packaging layer 313 covers the radio frequency power component 312 and packages the radio frequency power component 312. The radio frequency power component 312 may include a die (bare die) having a radio frequency power amplification function, and another circuit trace. A first input pad 314, a first output pad 315, and a first ground pad 316 are disposed on a surface of a side that is of the packaging layer 313 and that faces the first circuit board 32. The first input pad 314 is electrically connected to an input end of the radio frequency power component 312, the first output pad 315 is electrically connected to an output end of the radio frequency power component 312, and the first ground pad 316 is electrically connected to the flange 311.

It should be noted that, in this embodiment of this application, that A and B are electrically connected may mean that A and B are directly in contact and connected, to implement an electrical connection, or may mean that A and B are connected through a conductor (for example, a metal conductive pillar, a metal trace, or a jumper), to implement an electrical connection.

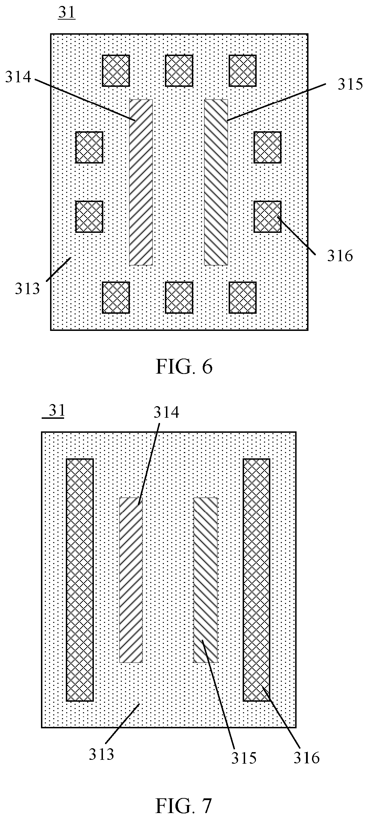

Still refer to FIG. 5. In a plane that is of the packaging layer 313 and that faces the first circuit board 32, the first ground pad 316 may be disposed on a periphery of the first input pad 314 and the first output pad 315, and the first input pad 314, the first output pad 315, and the first ground pad 316 are spaced apart. Shapes of the first input pad 314, the first output pad 315, and the first ground pad 316 are not limited. For example, in an embodiment, the first ground pad 316 may be a first annular ground pad, and the first input pad 314 and the first output pad 315 are located within the first annular ground pad 316, and are separately spaced from the first annular ground pad. FIG. 6 is another diagram of a power assembly according to an embodiment of this application. As shown in FIG. 6, in another embodiment, the first ground pad 316 may include a plurality of first ground solder joints, and the plurality of first ground solder joints are arranged in an annular manner around the periphery of the first input pad 314 and the first output pad 315. FIG. 7 is another diagram of a power assembly according to an embodiment of this application. As shown in FIG. 7, in another embodiment, the first ground pad 316 may include at least one first strip-shaped ground pad. Specifically, in an embodiment, the at least one first strip-shaped ground pad may include one first strip-shaped ground pad on the surface of the side that is of the packaging layer 313 and that faces the first circuit board 32. The first strip-shaped ground pad may be located on a side that is of the first input pad 314 and that faces away from the first output pad 315, or may be located on a side that is of the first output pad 315 and that faces away from the first input pad 314, or may be located on a same side of the first input pad 314 and the first output pad 315. In another embodiment, the at least one first strip-shaped ground pad may include two first strip-shaped ground pads, and the two first strip-shaped ground pads are disposed opposite to each other and in parallel. The first input pad 314 and the first output pad 315 are located between the two first strip-shaped ground pads.

As shown in FIG. 5, the flange 311 is electrically connected to the first ground pad 316. Specifically, in an embodiment, a conductive pillar 3111 is disposed on the surface of the side that is of the flange 311 and that faces the first circuit board 32, and the conductive pillar 3111 may penetrate the packaging layer 313 and be electrically connected to the first ground pad 316. In this embodiment of this application, a material of the conductive pillar 3111 may be different from a material of the flange 311, and the conductive pillar 3111 is connected to the flange 311 in a soldering manner. Certainly, the material of the conductive pillar 3111 may alternatively be the same as the material of the flange 311, and the conductive pillar 3111 and the flange 311 are made by using an integrated molding process. In some implementations, a plurality of conductive pillars 3111 may be disposed on the surface of the flange 311, and the plurality of conductive pillars 3111 may be arranged in an array.

When the first input pad 314 and the first output pad 315 are specifically disposed, the packaging layer 313 may be provided with a first penetrating via and a second penetrating via. The first penetrating via and the second penetrating via separately penetrate the packaging layer 313. A first conductor 3131 is disposed in the first penetrating via, and the first input pad 314 may be electrically connected to the radio frequency power component 312 through the first conductor 3131. A second conductor 3132 is disposed in the second penetrating via, and the first output pad 315 may be electrically connected to the radio frequency power component 312 through the second conductor 3132.

In addition, in an embodiment, the power assembly 31 may include two radio frequency power components 312. A conductive circuit 317 is further disposed on the surface of the side that is of the packaging layer 313 and that faces the first circuit board 32, and the conductive circuit 317 is configured to electrically connect to the two radio frequency power components 312. Specifically, the conductive circuit 317 may alternatively be connected to the two radio frequency power components 312 separately through two conductors, and details are not described herein again.

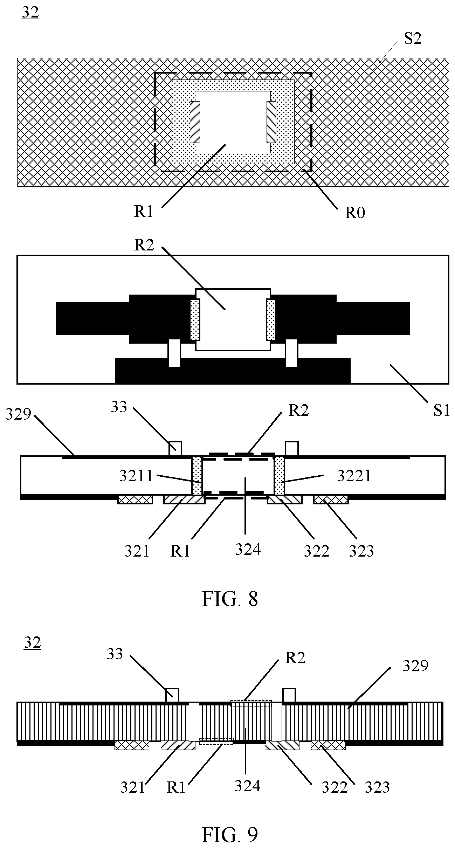

FIG. 8 is a diagram of a first circuit board according to an embodiment of this application. As shown in FIG. 8, the first circuit board 32 has a first surface S1 and a second surface S2 that are disposed opposite to each other. The first surface S1 is disposed facing the power assembly 31, and the second surface S2 is disposed facing away from the power assembly 31. A second input pad 321, a second output pad 322, and a second ground pad 323 are disposed on the first surface S1. Shapes of the second input pad 321, the second output pad 322, and the second ground pad 323 are not limited. The second input pad 321 and the first input pad 314 are disposed opposite to each other and electrically connected, the second output pad 322 and the first output pad 315 are disposed opposite to each other and electrically connected, and the second ground pad 323 and the first ground pad 316 are disposed opposite to each other and electrically connected, so that the power assembly 31 and the first circuit board 32 can be directly opposite to each other and connected, to reduce an assembling tolerance. It may be understood that, that A and B are disposed opposite to each other means that, along a direction perpendicular to the first circuit board 32, a projection of A onto the first surface S1 and a projection of B onto the first surface S1 at least partially overlap. "At least partially overlap" means that a part of the projection of A onto the first surface S1 overlaps a part of the projection of B onto the first surface S1; or the projection of A onto the first surface S1 covers the projection of B onto the first surface S1; or the projection of B onto the first surface S1 covers the projection of A onto the first surface S1; or the projection of A onto the first surface S1 fully overlaps the projection of B onto the first surface S1.

Refer to FIG. 8. Along the direction perpendicular to the first circuit board 32 (a vertical direction in FIG. 8), the power assembly 31 has a first projection area R0 on the first surface S1. The first surface S1 has a first demetallized area R1, the first demetallized area R1 is located in the first projection area R0, and the first demetallized area R1 is located between the second input pad 321 and the second output pad 322. The second surface S2 has a second demetallized area R2. Along the direction perpendicular to the first circuit board 32, a projection of the second demetallized area R2 onto the first surface S1 is located in the first projection area R0, and the second demetallized area R2 is located between the second input pad 321 and the second output pad 322. In this embodiment of this application, when the electronic assembly 30 operates, a radio frequency signal of the power assembly 31 is from the first input pad 314 to the first output pad 315. Therefore, a radio frequency signal path area is located between the first input pad 314 and the first output pad 315. In other words, the radio frequency signal path area is located between the second input pad 321 and the second output pad 322. In this way, the first demetallized area R1 and the second demetallized area R2 can reduce impact of the first circuit board 32 on the radio frequency signal of the power assembly 31, so that a problem such as a signal short circuit or cavity effect can be avoided.

In an embodiment, along the direction perpendicular to the first circuit board 32, the projection of the second demetallized area R2 onto the first surface S1 may at least partially overlap the first demetallized area R1. As shown in FIG. 8, in a specific embodiment, the projection of the second demetallized area R2 onto the first surface S1 may fully overlap the first demetallized area R1. FIG. 9 is another diagram of a first circuit board according to an embodiment of this application. As shown in FIG. 9, in another embodiment, the projection of the second demetallized area R2 onto the first surface S1 may not overlap the first demetallized area R1.

Specifically, the first demetallized area R1 and the second demetallized area R2 may be implemented in different manners. As shown in FIG. 8 and FIG. 9, in an embodiment, an insulating dielectric layer 324 is disposed in the first demetallized area R1 and the second demetallized area R2. The insulating dielectric layer 324 may be an insulating dielectric layer of the first circuit board 32. In this embodiment, when the first demetallized area R1 and the second demetallized area R2 are actually manufactured, a surface metal trace that is on the first surface S1 of the first circuit board 32 and that is located in the first demetallized area R1 is directly removed, to implement demetallization, and a surface metal trace that is on the second surface S2 of the first circuit board 32 and that is located in the second demetallized area R2, to implement demetallization. This manner is simple and easy to operate, and can reduce manufacturing costs of the first circuit board 32.

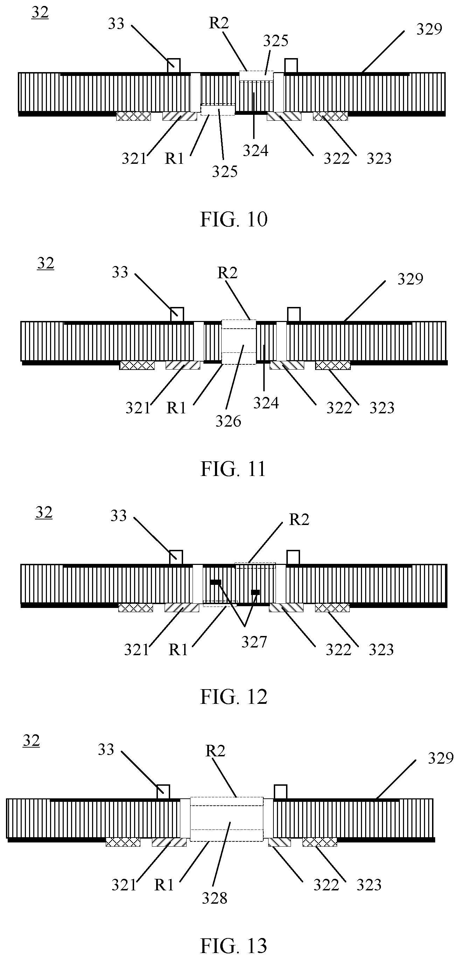

FIG. 10 is another diagram of a first circuit board according to an embodiment of this application. As shown in FIG. 10, in another embodiment, the insulating dielectric layer 324 may be provided with an open slot 325. Specifically, the open slot 325 may be provided in the first demetallized area R1, and an opening of the open slot 325 is provided toward the power assembly 31. The open slot 325 may also be provided in the second demetallized area R2, and the opening of the open slot 325 is provided in a direction facing away from the power assembly 31. FIG. 11 is another diagram of a first circuit board according to an embodiment of this application. As shown in FIG. 11, in another embodiment, the insulating dielectric layer 324 may be provided with a first through via 326. The first through via 326 penetrates the insulating dielectric layer 324, and is connected to the first demetallized area R1 and the second demetallized area R2. In other words, the entire first through via 326 may form a demetallized area that penetrates the first circuit board 32.

Certainly, it may be understood that, during actual application, the first circuit board 32 may be a multilayer circuit board. The multilayer circuit board may include at least three stacked metal circuit layers, and two adjacent metal circuit layers are spaced, through the insulating dielectric layer 324, for insulation. FIG. 12 is another diagram of a first circuit board according to an embodiment of this application. As shown in FIG. 12, during demetallization, metal portions located in the first surface S1 and the second surface S2 in the metal circuit layer are removed, but the metal circuit layer between two adjacent insulating dielectric layers 324 may be reserved, but at least a part of the metal circuit layer is demetallized. For example, in an embodiment, a metal portion 327 is further disposed in the insulating dielectric layer 324.

FIG. 13 is another diagram of a first circuit board according to an embodiment of this application. As shown in FIG. 13, certainly, in another embodiment, the first demetallized area R1 and the second demetallized area R2 may be directly connected through the second through via 328. In other words, no insulating dielectric layer 324 is disposed between the first demetallized area R1 and the second demetallized area R2 and between the second input pad 321 and the second output pad 322.

Still refer to FIG. 8. A third conductor 3211 and a fourth conductor 3221 are disposed in the first circuit board 32. The third conductor 3211 may be located in the first demetallized area R1 and the second demetallized area R2, and the third conductor 3211 is connected to the second input pad 321. The fourth conductor 3221 may be located in the first demetallized area R1 and the second demetallized area R2 and connected to the second output pad 322.

In the foregoing embodiment, a cross section that is of the third conductor 3211 and that is perpendicular to a thickness direction of the first circuit board 32 has a projection onto the first surface S1. The projection of the third conductor 3211 may fall within the second input pad 321. In other words, a size of the cross section of the third conductor 3211 is less than a size of the second input pad 321 on the first surface S1. Alternatively, the projection of the third conductor 3211 may fully overlap the second input pad 321. In other words, the size of the cross section of the third conductor 3211 is equal to the size of the second input pad 321 on the first surface S1. Alternatively, the projection of the third conductor 3211 may cover the second input pad 321. In other words, the size of the cross section of the third conductor 3211 is greater than the size of the second input pad 321 on the first surface S1. Similarly, a cross section that is of the fourth conductor 3221 and that is perpendicular to the thickness direction of the first circuit board 32 has a projection onto the first surface S1. The projection of the fourth conductor 3221 may fall within the second output pad 322. In other words, a size of the cross section of the fourth conductor 3221 is less than a size of the second output pad 322 on the first surface S1. Alternatively, the projection of the fourth conductor 3221 may fully overlap the second output pad 322. In other words, the size of the cross section of the fourth conductor 3211 is equal to the size of the second output pad 322 on the first surface S1. Alternatively, the projection of the fourth conductor 3221 may cover the second output pad 322. In other words, the size of the cross section of the fourth conductor 3221 is greater than the size of the second output pad 322 on the first surface S1.

As shown in FIG. 8, in a specific embodiment, in the first projection area R0, the first demetallized area R1 extends to the second input pad 321 and the second output pad 322 on the first surface S1, and the projection of the second demetallized area R2 onto the first surface S1 also extends to the second input pad 321 and the second output pad 322. In this embodiment, demetallization processing may also be performed on an area between the first surface S1 and the second surface S2 and an area between the third conductor 3211 and the fourth conductor 3221, to form a middle demetallized area. The middle demetallized area may be in an irregular shape. Specifically, along the direction perpendicular to the first circuit board, the first demetallized area R1 and the second demetallized area R2 may fully overlap, and a projection of the middle demetallized area onto the first surface S1 may be less than the first demetallized area R1, or may be equal to the first demetallized area R1 (that is, the projection of the middle demetallized area fully overlaps the first demetallized area R1), or may be greater than the first demetallized area R1.

In an embodiment, a routing portion 329 may be disposed on the second surface S2, and the second demetallized area R2 is disposed in the routing portion 329. The third conductor 3211 may be configured to electrically connect to the second input pad 321 and the third routing portion 329, and the fourth conductor 3221 may be configured to electrically connect to the second output pad 322 and the third routing portion 329.

During actual application, at least one discrete component 33 may be disposed on the second surface S2 of the first circuit board 32, and the at least one discrete component 33 may be electrically connected to the routing portion 329. In this application, the discrete component 33 includes but is not limited to an electronic component such as a resistor, a capacitor, or an inductor.

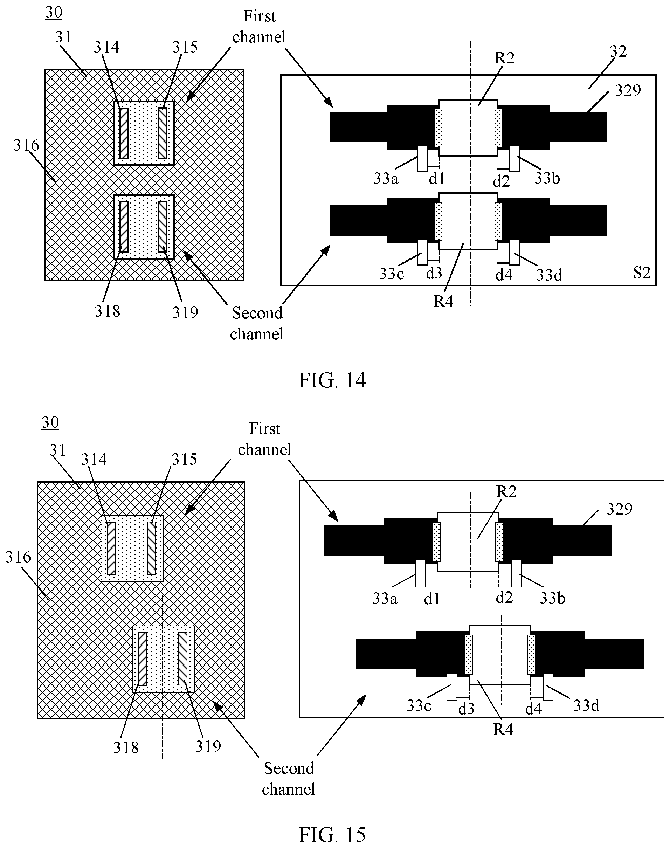

FIG. 14 is another diagram of an electronic assembly according to an embodiment of this application. As shown in FIG. 14, in an embodiment, the electronic assembly 30 may be a dual-channel assembly. Specifically, in the power assembly 31, a third input pad 318, a third output pad 319, and a third ground pad are further disposed on the surface that is of the packaging layer 313 and that faces the first circuit board 32. The third input pad 318 and the third output pad 319 are electrically connected to the radio frequency power component 312 separately, and the third ground pad is electrically connected to the flange 311. The first input pad 314 and the first output pad 315 may form a first channel, and the third input pad 318 and the third output pad 319 may form a second channel. The third ground pad and the first ground pad 316 may be of an integrally formed structure. Correspondingly, in the first projection area R0 of the first circuit board 32, a fourth input pad, a fourth output pad, and a fourth ground pad are further disposed on the first surface S1. The fourth input pad and the third input pad 318 are disposed opposite to each other and electrically connected, the fourth output pad and the third output pad 319 are disposed opposite to each other and electrically connected, and the fourth ground pad and the third ground pad are disposed opposite to each other and electrically connected. In addition, the first surface S1 further has a third demetallized area, and the third demetallized area is located in the first projection area R0 and located between the fourth input pad and the fourth output pad. The second surface S2 further has a fourth demetallized area R4, and along the direction perpendicular to the first circuit board 32, a projection of the fourth demetallized area R4 onto the first surface S1 is located in the first projection area R0 and located between the fourth input pad and the fourth output pad.

In the foregoing embodiment, in the surface of the side that is of the packaging layer 313 and that faces the first circuit board 32, the first input pad 314 and the third input pad 318 may be disposed in alignment, and the first output pad 315 and the third output pad 319 are disposed in alignment. In other words, the first channel and the second channel have a same center line (as shown by a dash-dot line in FIG. 14). FIG. 15 is another diagram of an electronic assembly according to an embodiment of this application. As shown in FIG. 15, the first channel and the second channel may alternatively be disposed in misalignment. In other words, the center line of the first channel may not overlap the center line of the second channel. In this embodiment, two discrete components 33 may be disposed on each channel. Specifically, a first discrete component 33a and a second discrete component 33b are disposed on the first channel, and the first discrete component 33a and the second discrete component 33b are respectively located on two sides of the second demetallized area R2. A third discrete component 33c and a fourth discrete component 33d are disposed on the second channel, and the third discrete component 33c and the fourth discrete component 33d are respectively located on two sides of the fourth demetallized area R4. In this way, the first channel and the second channel are independent of each other, and a risk of inter-channel layout interference can be reduced. It may be understood that the electronic assembly 30 in this application may alternatively be a three-channel assembly or a multi-channel assembly. This is not specifically limited herein.

In the foregoing embodiment, a first distance d1 between the first discrete component 33a and the second demetallized area R2, a second distance d2 between the second discrete component 33b and the second demetallized area R2, a third distance d3 between the third discrete component 33c and the fourth demetallized area R4, and a fourth distance d4 between the fourth discrete component 33d and the fourth demetallized area R4 may be set to equal distances, to improve a degree of freedom of design.

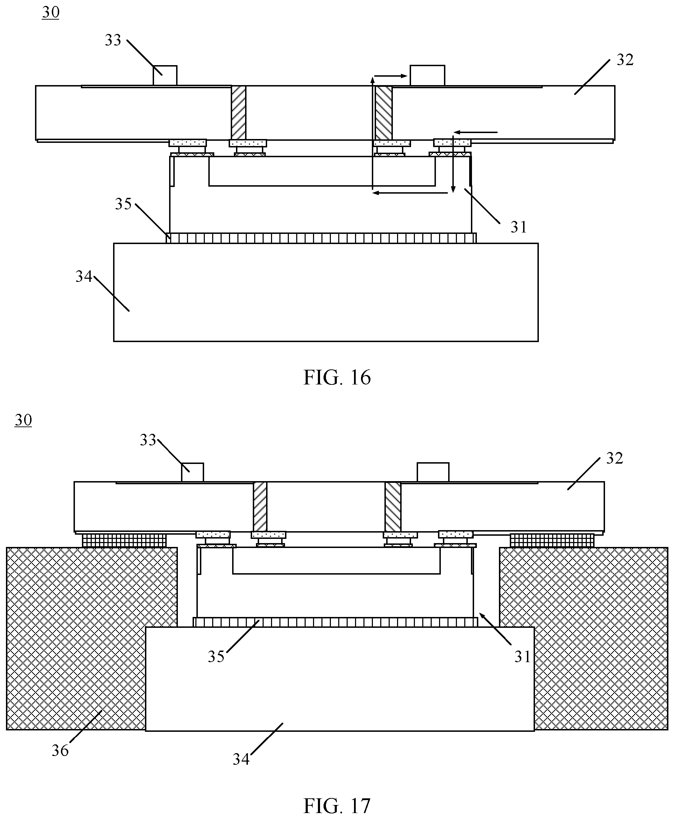

FIG. 16 is another diagram of an electronic assembly according to an embodiment of this application. As shown in FIG. 16, the electronic assembly 30 further includes a first heat sink 34. The first heat sink 34 is disposed on a side that is of the flange 311 and that faces away from the first circuit board 32, and is configured to dissipate heat for the power assembly 31. The first heat sink 34 may be configured only for heat dissipation, and does not need to be conductive.

When the electronic assembly 30 operates, a return path may sequentially pass through the second ground pad 323, the first ground pad 316, the flange 311, the first output pad 315, the second output pad 322, the fourth conductor 3221, and the discrete component 33 from the first circuit board 32. The return path does not need to pass through the first heat sink 34, and the path is short, so that consistency of the electronic assembly 30 can be better.

During actual application, a first thermally conductive layer 35 is disposed between the flange 311 and the first heat sink 34, to improve heat transfer efficiency of a surface that is of the flange 311 and that is in contact with the first heat sink 34, and the first thermally conductive layer 35 is in close contact with the surface of the flange 311 and a surface of the first heat sink 34 separately, to improve heat transfer efficiency.

FIG. 17 is another diagram of an electronic assembly according to an embodiment of this application. As shown in FIG. 17, in an embodiment, the electronic assembly 30 may be used in a multi-circuit board scenario. Specifically, the electronic assembly 30 further includes a second circuit board 36. The second circuit board 36 is located on a side that is of the first circuit board 32 and that faces the power assembly 31, the second circuit board 36 is fastened to the first circuit board 32, and the power assembly 31 is disposed in the second circuit board 36.

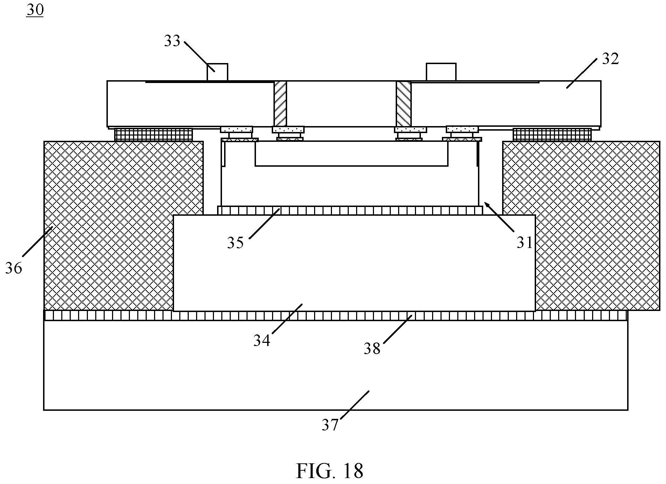

FIG. 18 is another diagram of an electronic assembly according to an embodiment of this application. As shown in FIG. 18, in an embodiment, the electronic assembly 30 further includes a second heat sink 37. The second heat sink 37 is located on a side that is of the second circuit board 36 and that faces away from the first circuit board 32, and the second heat sink 37 is located on a side that is of the first heat sink 34 and that faces away from the first circuit board 32. The second heat sink 37 may be configured to dissipate heat for the power assembly 31 and the second circuit board 36. A second thermally conductive layer 38 is disposed between the second circuit board 36 and the second heat sink 37, to improve heat transfer efficiency of a surface that is of the second circuit board 36 and that is in contact with the second heat sink 37, and the second thermally conductive layer 38 is in close contact with the surface of the second circuit board 36 and a surface of the second heat sink 37 separately. In addition, the second thermally conductive layer 38 may further extend between the first heat sink 34 and the second heat sink 37, and the second thermally conductive layer 38 is in close contact with the surface of the first heat sink 34 and the surface of the second heat sink 37 separately.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic assembly, comprising a power assembly and a first circuit board, wherein
the power assembly comprises a flange, a packaging layer, and a radio frequency power component; the packaging layer is located on a side that is of the flange and that faces the first circuit board, and is connected to the flange, and the radio frequency power component is disposed in the packaging layer; and a first input pad, a first output pad, and a first ground pad are disposed on a surface of a side that is of the packaging layer and that faces the first circuit board, the first input pad and the first output pad are electrically connected to the radio frequency power component separately, and the first ground pad is electrically connected to the flange;
a second input pad, a second output pad, and a second ground pad are disposed on a first surface that is of the first circuit board and that faces the power assembly, the second input pad and the first input pad are disposed opposite to each other and electrically connected, the second output pad and the first output pad are disposed opposite to each other and electrically connected, and the second ground pad and the first ground pad are disposed opposite to each other and electrically connected; and
along a direction perpendicular to the first circuit board, the power assembly has a first projection area on the first surface; the first surface has a first demetallized area, and the first demetallized area is located in the first projection area and located between the second input pad and the second output pad; and a second surface that is of the first circuit board and that faces away from the power assembly has a second demetallized area, and along the direction perpendicular to the first circuit board, a projection of the second demetallized area onto the first surface is located in the first projection area and located between the second input pad and the second output pad.

2. The electronic assembly according to claim 1, wherein along the direction perpendicular to the first circuit board, the projection of the second demetallized area onto the first surface at least partially overlaps the first demetallized area.

3. The electronic assembly according to claim 2, wherein along the direction perpendicular to the first circuit board, the projection of the second demetallized area onto the first surface fully overlaps the first demetallized area.

4. The electronic assembly according to claim 1, wherein along the direction perpendicular to the first circuit board, the projection of the second demetallized area onto the first surface does not overlap the first demetallized area.

5. The electronic assembly according to any one of claims 1 to 4, wherein an insulating dielectric layer is disposed between the first demetallized area and the second demetallized area, and the insulating dielectric layer is connected to the first demetallized area and the second demetallized area.

6. The electronic assembly according to claim 5, wherein the insulating dielectric layer is provided with an open slot, and an opening of the open slot is located in the first demetallized area or the second demetallized area; or
the insulating dielectric layer is provided with a first through via, and the first through via penetrates the insulating dielectric layer, and is connected to the first demetallized area and the second demetallized area.

7. The electronic assembly according to any one of claims 1 to 4, wherein a second through via is provided between the first demetallized area and the second demetallized area, and the second through via is connected to the first demetallized area and the second demetallized area.

8. The electronic assembly according to any one of claims 1 to 7, wherein a first conductor and a second conductor are disposed on the first circuit board, the first conductor is located in the first demetallized area and the second demetallized area, and is connected to the second input pad, and the second conductor is located in the first demetallized area and the second demetallized area, and is connected to the second output pad.

9. The electronic assembly according to claim 8, wherein a routing portion is disposed on the second surface, and the second demetallized area is disposed in the routing portion; and the first conductor is electrically connected to the second input pad and the routing portion, and the second conductor is electrically connected to the second output pad and the routing portion.

10. The electronic assembly according to any one of claims 1 to 9, wherein the packaging layer is provided with a first penetrating via and a second penetrating via, the first penetrating via and the second penetrating via penetrate the packaging layer separately, a third conductor is disposed in the first penetrating via, the first input pad is electrically connected to the radio frequency power component through the third conductor, a fourth conductor is disposed in the second penetrating via, and the second input pad is electrically connected to the radio frequency power component through the fourth conductor.

11. The electronic assembly according to any one of claims 1 to 10, wherein a fifth conductor is disposed on a surface of a side that is of the flange and that faces the first circuit board, and the fifth conductor penetrates the packaging layer, and is electrically connected to the flange and the first ground pad.

12. The electronic assembly according to any one of claims 1 to 11, wherein the electronic assembly is a dual-channel assembly;
a third input pad, a third output pad, and a third ground pad are further disposed on the surface of the side that is of the packaging layer and that faces the first circuit board, the third input pad and the third output pad are electrically connected to the radio frequency power component separately, and the third ground pad is electrically connected to the flange;
a fourth input pad, a fourth output pad, and a fourth ground pad are further disposed on the first surface, the fourth input pad and the third input pad are disposed opposite to each other and electrically connected, the fourth output pad and the third output pad are disposed opposite to each other and electrically connected, and the fourth ground pad and the third ground pad are disposed opposite to each other and electrically connected; and
the first surface further has a third demetallized area, and the third demetallized area is located in the first projection area and located between the fourth input pad and the fourth output pad; and the second surface further has a fourth demetallized area, and along the direction perpendicular to the first circuit board, a projection of the fourth demetallized area onto the first surface is located in the first projection area and located between the fourth input pad and the fourth output pad.

13. The electronic assembly according to claim 12, wherein a first discrete component, a second discrete component, a third discrete component, and a fourth discrete component are disposed on the side that is of the first circuit board and that faces away from the power assembly, the first discrete component and the second discrete component are respectively located on two sides of the second demetallized area, and the third discrete component and the fourth discrete component are respectively located on two sides of the fourth demetallized area.

14. The electronic assembly according to any one of claims 1 to 13, wherein the electronic assembly further comprises a first heat sink, and the first heat sink is disposed on a side that is of the flange and that faces away from the first circuit board, and is configured to dissipate heat for the power assembly.

15. The electronic assembly according to claim 14, wherein a first thermally conductive layer is disposed between the flange and the first heat sink.

16. The electronic assembly according to any one of claims 1 to 15, wherein the electronic assembly further comprises a second circuit board, the second circuit board is located on the side that is of the first circuit board and that faces the power assembly, the second circuit board is connected to the first circuit board, and the power assembly is disposed in the second circuit board.

17. A communication device, comprising the electronic assembly according to any one of claims 1 to 16.
